# EUROPEAN PATENT SPECIFICATION

(11) **EP 1 039 501 B1**
(45) Date of publication and mention of the grant of the patent: **09.11.2005**
(21) Application number: 00101598.1
(22) Date of filing: 27.01.2000
(51) Int. Cl.: H01J 37/32, H01L 21/02, C23C 16/515

(54) **Apparatus and method for production of electronic devices**
Apparat und Verfahren zur Herstellung von Halbleitervorrichtungen
Appareil et procédé pour la fabrication d'un dispositif semi-conducteur

(30) Priority: 29.01.1999 JP 2227499
(43) Date of publication of application: 27.09.2000
(73) Proprietor: SHARP KABUSHIKI KAISHA, Osaka 545-8522 (JP)
(72) Inventor: Mashima, Satoshi, Kitakatsuragi-gun, Nara 639-2163 (JP); Monoto, Katsuhiko, Kashiwara-shi, Osaka 582-0019 (JP)
(74) Representative: Müller - Hoffmann & Partner

(56) References cited:
- EP-A- 0 653 501
- PATENT ABSTRACTS OF JAPAN vol. 1995, no. 09, 31 October 1995 (1995-10-31) & JP 07 166358 A (ULVAC JAPAN LTD), 27 June 1995 (1995-06-27)
- WATANABE Y ET AL: "POWDER-FREE PLASMA CHEMICAL VAPOR DEPOSITION OF HYDROGENATED AMORPHOUS SILICON WITH HIGH RF POWER DENSITY USING MODULATED RF DISCHARGE" APPLIED PHYSICS LETTERS, AMERICAN INSTITUTE OF PHYSICS. NEW YORK, US, vol. 57, no. 16, 15 October 1990 (1990-10-15), pages 1616-1618, XP000163165 ISSN: 0003-6951

## Description

### BACKGROUND OF THE INVENTION

### 1. Field of the Invention

The present invention relates to an apparatus and a method for production of electronic devices and, more particularly, to an apparatus and a method for production of electronic devices, which are suitable, in the electronic industry, for a plasma excited chemical vapor deposition apparatus (hereinafter referred to as "plasma CVD apparatus") for forming a semiconductor film or an insulating film such as of hydrogenated amorphous silicon (hereinafter referred to as "a-Si:H"), or for a plasma etching device for processing a semiconductor device or a liquid crystal device.

### 2. Description of the Related Art

Plasma CVD apparatuses for deposition of a thin film in a gaseous atmosphere produced by plasma excitation and decomposition of a material gas and plasma etching apparatuses for processing a semiconductor device or a liquid crystal display device are widely used for production of electronic devices which involves processing of a metal film, a semiconductor film and/or a dielectric film, or a crystalline wafer.

In order to achieve a higher through-put (productivity) in these production apparatuses, it is particularly important to process a multiplicity of substrates at a time. To this end, the size of a reaction chamber, the sizes of cathode and anode electrodes and the numbers of the cathode and anode electrodes are increased.

It is also important to increase the processing speeds of the apparatuses for a higher through-put. One known approach to the increase of the processing speed for film deposition is to employ a high-speed and high-quality a-Si:H film deposition technique by a short-pulse VHF plasma CVD method (see, for example, Japanese Unexamined Patent Publication No. Hei 7(1995)-166358).

The processing speed of a plasma CVD apparatus may be increased by increasing an electric power, a frequency or the like for the plasma discharge. If the processing speed exceeds a certain level, however, abnormal discharge phenomena such as production of particles (powder) and occurrence of discharge in an unintended space (other than a space where a substrate to be processed is placed) are liable to take place, making it impossible to carry out a desired process.

It has been known that pulse-modulated discharge is effective for suppression of the production of the particles (Y.Watanabe, et al., Appl. Phys. Lett., 57. 1616 (1990)).

The level of the electric power at which the abnormal discharge starts occurring depends upon the discharge frequency, the size of electrodes and the like which are employed for the discharge. For a higher through-put, it is necessary to process a multiplicity of substrates at a time, i.e., to increase the number of electrodes.

Where a high frequency power is applied to a plurality of electrodes placed in a single space (in a vacuum vessel), however, plasma interference occurs, so that the abnormal discharge phenomena are liable to occur. This results in a reduction in processing speed per electrode as compared with a case where a single electrode is employed.

### SUMMARY OF THE INVENTION

In view of the foregoing, the present invention is directed to providing a production apparatus and a production method, which prevent the reduction in processing speed per-electrode when a plurality of electrodes are employed for processing a plurality of substrates, thereby drastically improving the mass-productivity of electronic devices such as solar batteries and liquid crystal display devices which utilize a-Si:H thin films in the electronic industry.

In accordance with one aspect of the present invention, there is provided an apparatus for production of electronic devices, which comprises: a vacuum vessel having first and second pairs of opposed electrodes provided therein; a gas inlet for introducing a material gas into the vacuum vessel; and first and second power sources for applying first and second high frequency voltages between the first pair of electrodes and between the second pair of electrodes, respectively, to cause plasma discharge, the first and second high frequency voltages being modulated in accordance with first and second pulse waves, respectively; wherein ON periods of the first and second pulse waves are controlled so as not to coincide with each other.

In accordance with another aspect of the present invention, there is provided a method for production of electronic devices, which comprises the steps of: placing components to be processed between a first pair of opposed electrodes and between a second pair of opposed electrodes in a vacuum vessel; introducing a material gas into the vacuum vessel; and applying first and second high frequency voltages between the first pair of electrodes and between the second pair of electrodes, respectively, to cause plasma discharge, the first and second high frequency voltages being modulated in accordance with first and second pulse waves, respectively; wherein ON periods of the first and second pulse waves are controlled so as not to coincide with each other.

### BRIEF DESCRIPTION OF THE DRAWINGS

Fig. 1 is a diagram illustrating the construction of an electronic device production apparatus which is applied to a plasma CVD apparatus in accordance with an embodiment of the present invention; and
Fig. 2 is a timing chart showing modulating pulse waveforms in accordance with the embodiment of the present invention.

### DETAILED DESCRIPTION OF THE INVENTION

In the present invention, the expression "first and second pairs of opposed electrodes" means at least two pairs of opposed electrodes, so that three or more pairs of opposed electrodes may be employed. The opposed electrodes are, for example, electrode plates opposed to each other in a parallel relation.

A component, such as a wafer, to be processed is placed on one of the opposed electrodes in each pair. The one electrode on which the component is to be placed is generally referred to as a cathode electrode, which is grounded. The other electrode is referred to as an anode electrode.

In the present invention, the vacuum vessel is designed so that the material gas introduced therein can be maintained at a pressure level of about 10⁻¹ torr to about 1 torr.

Where the inventive apparatus is employed as a plasma CVD apparatus for formation of a-Si:H films, SiH₄, Si₂H₆, a gas mixture containing SiH₄ or Si₂H₆ and any of CH₄, C₂H₆, PH₃, B₂H₆ and GeH₄, or a gas mixture containing any of H₂, He, Ar, Xe and Kr diluted with SiH₄ or Si₂H₆, for example, is used as the material gas. For formation of an Si oxide film, an SiH₄-N₂O gas, for example, is used as the material gas.

Where the inventive apparatus is employed as a plasma etching apparatus, CF₄, CF₃, Cl, CF₂, Cl₂, CFCl₃, CF₃BR or CCl₄ is used as a reaction gas for processing of an Si-based component, and CF₄, C₂F₆, C₃F₈ or CHF₃ is used as a reaction gas for processing of an SiO₂-based component.

In the present invention, the gas inlet is adapted to supply the gas into the vacuum vessel, for example, from a gas cylinder. The first and second power sources are adapted to output pulse-modulated high frequency voltages to cause plasma discharge between the first pair of electrodes and between the second pair of electrodes, respectively. The high frequency outputs of the first and second power sources preferably have the same frequency, but may have different frequencies.

The frequency of the high frequency voltage may be in a frequency band between a radio frequency and a ultra high frequency, for example, including a radio frequency of 13.56MHz, a very high frequency (VHF on the order of several tens MHz) and a ultra high frequency (UHF on the order of several hundreds MHz).

The first and second power sources are adapted to pulse-modulate the high frequency voltages in accordance with first and second pulse waves, respectively, and apply the pulse-modulated voltages between the respective pairs of electrodes. At this time, the ON periods of the modulating pulse waves are controlled by the first and second power-sources so as not to coincide with each other. This prevents the plasma discharge interference between the first pair of electrodes and the second pair of electrodes even if the power for the plasma discharge is increased. Accordingly, the abnormal discharge can be prevented.

The ON periods of the modulating pulse waves may be from 1µs to 100µs, and the OFF periods of the pulse waves may be from 5µs to 500µs. A duty ratio of not greater than 20% for the modulating pulse waves further effectively prevents the abnormal discharge.

The present invention will hereinafter be described in detail by way of an illustrated embodiment.

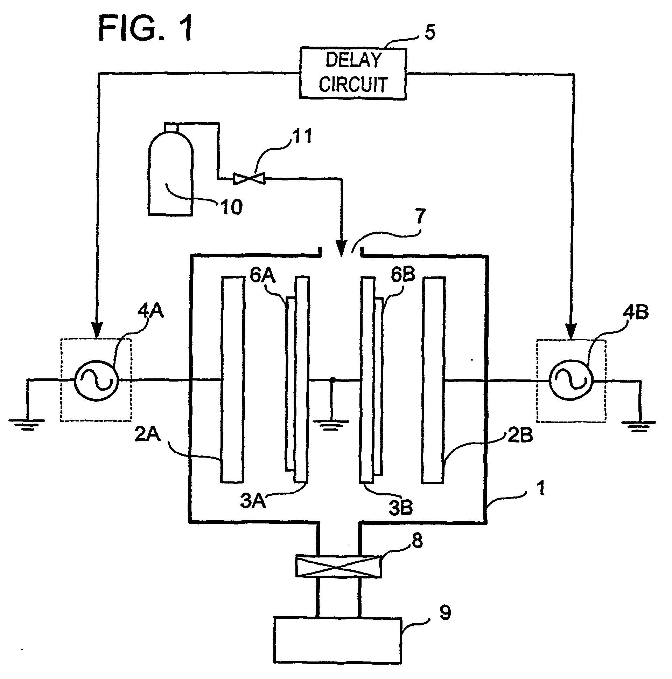

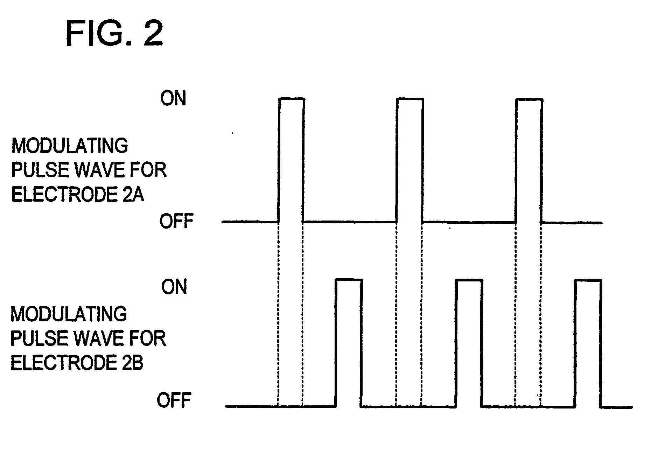

Fig. 1 is a diagram illustrating the construction of an electronic device production apparatus, and Fig. 2 is a timing chart of modulating pulse waves for modulating the high frequency voltages applied between respective pairs of electrodes in the apparatus. The electronic device production apparatus is herein used as a plasma CVD apparatus.

As shown in Fig. 1, two anode electrodes 2A and 2B and two cathode electrodes 3A and 3B are disposed in a parallel relation within a vacuum vessel 1. Substrates to be processed (components to be processed) 6A and 6B are placed on the cathode electrodes 3A and 3B, respectively. The cathode electrodes 3A, 3B are electrically grounded to the vacuum vessel 1, and therefore their potentials are at a ground level.

A gas inlet 7 is provided at the top of the vacuum vessel 1, and a material gas is introduced into the vacuum vessel 1 from a gas cylinder 10 through a valve 11 and the gas inlet 7. The gas introduced into the vacuum vessel 1 is drawn out via a main valve 8 by a vacuum pump 9.

Pulse-modulated high frequency power generators 4A and 4B are connected to the anode electrodes 2A and 2B, respectively, via lines extending through central portions of right and left walls of the vacuum vessel 1. By a pulse signal delay circuit 5, the ON periods of modulating pulse waves for modulating the high frequency voltages applied to the respective anode electrodes 2A, 2B are controlled so as not to coincide with each other.

The vacuum vessel 1 has a sectional area of 1.6m x 1.6m as measured parallel to the surfaces of the electrodes. The anode electrodes 2A, 2B and the cathode electrodes 3A, 3B each have a size of 700mm x 700mm.

A gas mixture of silane and hydrogen is used as the material gas. Discharge parameters to be employed include a frequency of 27.12MHz, an ON period of the modulating pulse waves of 10µsec, and a duty ratio of 20%.

Under such conditions, plasma discharge is allowed to occur between the electrodes 2A and 3A and between the electrodes 2B and 3B with the material gas being introduced into the vacuum vessel 1 to form a-Si:H films on the respective substrates 6A and 6B. In an experiment, when the ON periods of the modulating pulse waves for modulating the high frequency voltages applied to the anode electrodes 2A and 2B are allowed to coincide with each other, abnormal discharge occurred at a discharge power of 500W.

When the ON periods of the pulse waves are offset from each other by 25µsec, normal discharge (between the anode electrodes and the cathode electrodes) is ensured at a discharge power up to 950W. Therefore, the apparatus allows for high speed film formation even when two substrates are simultaneously processed, thereby improving the mass-productivity.

Although an explanation has been given to a case where the electronic device production apparatus is applied to the plasma CVD apparatus in this embodiment, the electronic device production apparatus is applicable to a plasma dry etching apparatus for etching a film with species activated by plasma particles and plasma excitation, and provides for the same effects.

Where the electronic device production apparatus according to the present invention is applied to a plasma CVD apparatus for processing a plurality of substrates with the use of plural pairs of electrodes, the reduction in the processing speed per electrode pair can be prevented, thereby improving the mass-productivity of electronic devices such as solar batteries and liquid crystal display devices which utilize a-Si:H thin films in the electronic industry.

Where the electronic device production apparatus according to the present invention is applied to a plasma etching apparatus for etching a film with species activated by plasma particles and plasma excitation, the mass-productivity of electronic devices such as liquid crystal display devices can be improved.

## Claims

1. An apparatus for production of electronic devices, which comprises:
a vacuum vessel (1) having first (2A, 3A) and second pairs (2B, 3B) of opposed electrodes provided therein, wherein components to be processed (6A, 6B) can be placed between the electrodes of each pair;
a gas inlet (7) for introducing a material gas into the vacuum vessel; and
first and second power sources (4A, 4B) for applying first and second high frequency voltages between the first pair of electrodes and between the second pair of electrodes, respectively, to cause plasma discharge, the first and second high frequency voltages being modulated in accordance with first and second pulse waves, respectively;
wherein ON periods of first and second pulse waves are controlled so as not to coincide with each other.

2. An apparatus as set forth in claim 1, wherein each of the first and second high frequency voltages has a frequency in a frequency band between a radio frequency and a ultra high frequency.

3. An apparatus as set forth in claim 1, wherein the ON periods of the first and second pulse waves are from 1µs to 100µs, and OFF periods of the first and second pulse waves are from 5µs to 500µs.

4. An apparatus as set forth in claim 1, wherein the first and second pulse waves have a duty ratio of not greater than 20%.

5. A method for production of electronic devices, which comprises the steps of:
placing components to be processed between a first pair of opposed electrodes and between a second pair of opposed electrodes in a vacuum vessel;
introducing a material gas into the vacuum vessel; and
applying first and second high frequency voltages between the first pair of electrodes and between the second pair of electrodes, respectively, to cause plasma discharge, the first and second high frequency voltages being modulated in accordance with first and second pulse waves, respectively;
wherein ON periods of the first and second pulse waves are controlled so as not to coincide with each other.

6. An apparatus as set forth in claim 5, wherein each of the high frequency voltages has a frequency in a frequency band between a radio frequency and a ultra high frequency.

7. An apparatus as set forth in claim 5, wherein the ON periods of the first and second pulse waves are from 1µs to 100µs, and OFF periods of the pulse waves are from 5µs to 500µs.

8. An apparatus as set forth in claim 5, wherein the first and second pulse waves have a duty ratio of not greater than 20%.

## Patentansprüche

1. Vorrichtung zur Herstellung elektronischer Geräte mit:
einem Vakuumbehälter (1), in dem ein erstes (2A, 3A) und zweites (2B, 3B) Paar von gegenüberliegenden Elektroden angeordnet ist, wobei die zu verarbeitenden Komponenten (6A, 6B) zwischen den Elektroden eines jeden Paars angeordnet werden können,
einem Gaseinlass (7) zum Einführen eines Materialgases in den Vakuumbehälter; und
einer ersten und einer zweiten Spannungsquelle (4A, 4B) zum Anlegen einer ersten und einer zweiten Hochfrequenzspannung zwischen dem ersten Paar von Elektroden bzw. zwischen dem zweiten Paar von Elektroden, um eine Plasmaentladung zu bewirken, wobei die erste und die zweite Hochfrequenzspannung in Übereinstimmung mit einer ersten bzw. zweiten Impulswelle moduliert wird;
wobei "An"-Zeiträume der ersten und zweiten Impulswelle so gesteuert werden, dass sie nicht zusammenfallen.

2. Vorrichtung nach Anspruch 1, wobei sowohl die erste als auch die zweite Hochfrequenzspannung eine Frequenz in einem Frequenzband zwischen einer Radiofrequenz und einer Ultrahochfrequenz besitzt.

3. Vorrichtung nach Anspruch 1, wobei die "An"-Zeiträume der ersten und zweiten Impulswelle von 1 µs bis 100 µs dauern, und die "Aus"-Zeiträume der ersten und zweiten Impulswelle von 5 µs bis 500 µs dauern.

4. Vorrichtung nach Anspruch 1, wobei die erste und zweite Impulswelle eine relative Einschaltdauer von nicht mehr als 20% besitzen.

5. Verfahren zur Herstellung elektronischer Geräte mit folgenden Schritten:
Anordnen von zu verarbeitenden Komponenten zwischen einem ersten Paar von gegenüberliegenden Elektroden und einem zweiten Paar von gegenüberliegenden Elektroden in einem Vakuumbehälter;
Einführen eines Materialgases in den Vakuumbehälter; und
Anlegen einer ersten und einer zweiten Hochfrequenzspannung zwischen dem ersten Paar von Elektroden bzw. zwischen dem zweiten Paar von Elektroden, um eine Plasmaentladung zu bewirken, wobei die erste und die zweite Hochfrequenzspannung in Übereinstimmung mit einer ersten bzw. einer zweiten Impulswelle moduliert wird;
wobei "An"-Zeiträume der ersten und zweiten Impulswelle so gesteuert werden, dass sie nicht zusammenfallen.

6. Vorrichtung nach Anspruch 5, wobei jede der Hochfrequenzspannungen eine Frequenz in einem Frequenzband zwischen einer Radiofrequenz und einer Ultrahochfrequenz besitzt.

7. Vorrichtung nach Anspruch 5, wobei die "An"-Zeiträume der ersten und zweiten Impulswelle von 1 µs bis 100µs dauern, und "Aus"-Zeiträume der Impulswellen von 5 µs bis 500 µs dauern.

8. Vorrichtung nach Anspruch 5, wobei die erste und zweite Impulswelle eine relative Einschaltdauer von nicht mehr als 20% besitzen.

## Revendications

1. Appareil de fabrication de dispositifs électroniques, comprenant :
une enceinte sous vide (1), comportant une première paire (2A, 3A) et une seconde paire (2B, 3B) d'électrodes opposées, disposées à l'intérieur de celle-ci, des composants (6A, 6B) à traiter pouvant être placés entre les électrodes de chaque paire ;
un orifice d'admission dé gaz (7) servant à l'introduction d'une matière à l'état gazeux, dans l'enceinte sous vide ; et
des première et seconde sources d'alimentation en énergie (4A, 4B) pour appliquer des première et seconde tensions à haute fréquence, respectivement entre la première paire d'électrodes et entre la seconde paire d'électrodes afin de provoquer une décharge plasma, les première et seconde tensions à haute fréquence étant modulées suivant, respectivement, des première et seconde ondes impulsionnelles ;
dans lequel des périodes d'application des première et seconde ondes impulsionnelles sont commandées de telle manière qu'elles ne coïncident pas.

2. Appareil selon la revendication 1, dans lequel chacune des première et seconde tensions à haute fréquence a une fréquence située dans une gamme de fréquences comprise entre une radiofréquence et une ultra-haute fréquence.

3. Appareil selon la revendication 1, dans lequel les périodes d'application des première et seconde ondes impulsionnelles sont situées entre 1 µs et 100 µs, et les périodes de coupure des première et seconde ondes impulsionnelles sont situées entre 5 µs et 500 µs.

4. Appareil selon la revendication 1, dans lequel les première et seconde ondes impulsionnelles ont un rapport cyclique non supérieur à 20 %.

5. Procédé de fabrication de dispositifs électroniques, comprenant les étapes de :
mise en place de composants à traiter, entre une première paire d'électrodes opposées, et entre une seconde paire d'électrodes opposées, dans une enceinte sous vide ;
introduction d'une matière à l'état gazeux, dans l'enceinte sous vide ; et
application d'une première et d'une seconde tension à haute fréquence, respectivement entre la première paire d'électrodes et entre la seconde paire d'électrodes afin de provoquer une décharge plasma, les première et seconde tensions à haute fréquence étant modulées suivant, respectivement, des première et seconde ondes impulsionnelles ;
dans lequel des périodes d'application des première et seconde ondes impulsionnelles sont commandées de telle manière qu'elles ne coïncident pas.

6. Appareil selon la revendication 5, dans lequel chacune des tensions à haute fréquence a une fréquence située dans une gamme de fréquences comprise entre une radiofréquence et une ultra-haute fréquence.

7. Appareil selon la revendication 5, dans lequel les périodes d'application des première et seconde ondes impulsionnelles sont situées entre 1 µs et 100 µs, et les périodes de coupure des première et seconde ondes impulsionnelles sont situées entre 5 µs et 500 µs.

8. Appareil selon la revendication 5, dans lequel les première et seconde ondes impulsionnelles ont un rapport cyclique non supérieur à 20 %.
